(19) **Europäisches Patentamt**
**European Patent Office**
**Office européen des brevets**

(11) **EP 4 667 616 A1**

(12) **EUROPEAN PATENT APPLICATION**

(43) Date of publication:
24.12.2025 Bulletin 2025/52

(21) Application number: 25180601.4

(22) Date of filing: 03.06.2025

(51) International Patent Classification (IPC):
*C23C 16/24* (2006.01)     *C23C 16/455* (2006.01)
*C23C 16/56* (2006.01)

(52) Cooperative Patent Classification (CPC):
C23C 16/24; C23C 16/45523; C23C 16/45553;
C23C 16/56

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  04.06.2024  KR 20240073014

(71) Applicant: **Hansol Chemical Co., Ltd**
**Seoul 06169 (KR)**

(72) Inventors:
• **HAN, Jeong-Woo**
  **55146 Jeonju-si, Jeonbuk-do (KR)**
• **CHO, Eun-Jeong**
  **54835 Jeonju-si, Jeonbuk-do (KR)**
• **AN, Jae-Seok**
  **55334 Wanju-gun, Jeonbuk-do (KR)**

(74) Representative: **Ipsilon**
**Le Contemporain**
**50 Chemin de la Bruyère**
**69574 Dardilly Cedex (FR)**

(54) **METHOD FOR THE FORMATION OF THIN FILMS USING TWO TYPES OF SILICON PRECURSOR**

(57)    Proposed is a silicon thin film formation method using two types of silicon precursor compounds. Specifically, proposed is a silicon thin film formation method in which a thin film exhibits excellent properties through atomic layer deposition (ALD) even at a low temperature, and the morphology is controllable depending on the precursor.

EP 4 667 616 A1

**Description**

BACKGROUND OF THE INVENTION

1. Technical Field

The present application relates to a silicon thin film formation method in which a silicon thin film has excellent properties through atomic layer deposition (ALD) using two types of silicon precursors even at a low temperature.

2. Description of the Related Art

Silicon-containing thin films can recently be formed in various types through diverse processes in the semiconductor field. In particular, silicon oxide films and silicon nitride films are usable as insulating films, diffusion barrier films, hardmasks, etch stop layers, seed layers, spacers, trench isolation, intermetallic dielectric materials, or protective film layers in device fabrication due to having excellent barrier properties and oxidation resistance. Polycrystalline silicon thin films have recently been used in thin film transistors (TFTs), solar cells, and the like, and the application fields thereof are gradually diversifying.

Representative technologies known for forming silicon-containing thin films include ALD, in which a gaseous precursor is adsorbed physically or chemically onto the surface of a substrate, and then a film is formed by introducing a reaction gas in sequence, and metalorganic chemical vapor deposition (MOCVD), in which a mixed gaseous organometallic precursor and a reaction gas react to form a film on the surface of a substrate or react directly on the surface to form a film. In addition, various thin film formation technologies using the aforementioned technologies include low-pressure chemical vapor deposition (LPCVD), plasma-enhanced chemical vapor deposition (PECVD) and plasma-enhanced atomic layer deposition (PEALD), both using plasma enabling low-temperature deposition, and the like. These technologies are applied to the formation processes of devices, such as next-generation semiconductors, and are used to form ultra-fine patterns and deposit thin films that are uniform in thickness at the nanoscale and have excellent properties.

In particular, thin films used in semiconductor devices must be controllable at the atomic level and have excellent step coverage. A technology applicable to this is ALD. As the development of highly isotopic thin film deposition methods enabling nanoscale thickness control becomes a significantly important factor, ALD is gaining attention as the most promising deposition technique for a wide range of applications to nanoscale devices. There are expectations that ALD will be able to solve problems, such as high leakage current, caused by device miniaturization. Furthermore, an additional advantage of ALD is that thin films involving atomic-level compositional variations, other than single high-dielectric materials, can be deposited. The principle of ALD is that a single atomic layer is deposited by supplying each reactant onto the surface of a wafer, with the reactants separated by an inert gas (such as Ar or $N_2$), in which case, the deposition cycle is repeatedly performed to deposit the desired thickness. A thin film is formed through a reaction where one reactant is first chemically adsorbed onto a substrate onto which the thin film is to be deposited, and then a second or third gas is introduced and chemically absorbed again onto the substrate. Either a simple element or a compound is used as the reactant, and such a reactant is required to be highly volatile, stable, and highly reactive.

However, existing ALD precursors require high-temperature processes at 600°C or higher, during which reactants decompose, causing defects and resulting in problems with deterioration in the physical and electrical properties of thin films, such as step coverage and etching characteristics.

Hence, there is a growing need for a process that enables low-temperature behaviors of the deposition process, adhesion of the thin film, excellent step coverage, and thickness control at the atomic layer level.

Ultimately, there is a need to develop a thin film formation method in which an ALD process is possible even at a low temperature, and a thin film has excellent step coverage and exhibits excellent properties.

Document of Related Art

Patent Document

(Patent Document 1) Korean Patent No. 10-1436564

SUMMARY

The present application aims to provide a thin film formation method enabling a thin film to be efficiently formed using two types of silicon precursors even at a low temperature and a thin film having excellent properties formed thereby.

In particular, in existing silicon thin film deposition, silicon thin films containing defects have been formed due to LPCVD. As a result, during high-temperature crystallization, polycrystalline silicon (poly-Si) thin films having a small grain boundary size have been formed.

Hence, the present application aims to provide a thin film formation method securing low-temperature ALD behaviors even at 500°C or lower and enabling conformal deposition even on patterns with a high aspect ratio by applying two types of silicon precursors to ALD utilizing thermal energy instead of existing plasma.

However, the problems to be solved by the present application are not limited to the aforementioned description, and other problems not mentioned can be clearly understood by those skilled in the art from the following description.

However, the problems to be pursued by the present invention are not limited to the aforementioned description, and other problems not mentioned but to be solved can be clearly understood by those skilled in the art to which the present disclosure pertains from the following description.

Provided is a thin film formation method of depositing a thin film by repeatedly performing a first cycle including: performing a first injection to inject a first precursor compound into a chamber; and

> performing a second injection to inject a second precursor compound into the chamber,
> wherein the first precursor compound is represented by Chemical Formula 1 below, and
> the second precursor compound is represented by Chemical Formula 2 below.

$$[\text{Chemical Formula 1}] \qquad Si(R_1)_x H_{(4-x)}$$

$$[\text{Chemical Formula 2}] \qquad Si_y(R_2)_z H_{(2y+2-z)}$$

In Chemical Formulas 1 and 2,

> $R_1$ and $R_2$ are each independently any one selected from the group consisting of fluorine (F), chlorine (Cl), bromine (Br), and iodine (I),
> x is an integer in the range of 1 to 4,
> z is an integer in the range of 0 to 4 when y is 1, and
> z is an integer in the range of 0 to 6 when y is 2 or 3.

A thin film formation method of the present application can efficiently form a silicon thin film having excellent properties.

Specifically, in the present application, an ALD process is possible even at a low temperature of 500°C or lower by introducing two types of silicon precursor compounds, in which case, the two types of precursor compounds serve as a source and a reactant, and a thin film that is amorphous or nanocrystalline can be deposited depending on the types of precursor compounds.

In particular, by depositing an amorphous silicon thin film, a polycrystalline silicon thin film having a large grain boundary size can be formed during crystallization.

In other words, the thin film formation method of the present application enables uniform deposition of a thin film having excellent properties even at a low temperature by using two types of silicon precursor compounds. Accordingly, the thin film can secure excellent physical properties, thickness, and step coverage, and the morphology and crystallinity of the deposited thin film can be controlled.

In addition, the thin film having excellent properties, formed by the thin film formation method of the present disclosure, can be used in dielectrics, displays, next-generation memories, non-memory semiconductors, and the like of various electronic devices.

BRIEF DESCRIPTION OF THE DRAWINGS

> FIG. 1 is a schematic diagram of a process in which a silicon seed layer is formed and oxidized or nitrided; and
> FIG. 2 is a schematic diagram of a process in which a silicon thin film is formed and oxidized or nitrided.

DESCRIPTION OF THE PREFERRED EMBODIMENTS

Hereinafter, the action and effect of the present disclosure will be described in more detail through specific embodiments and drawings of the present disclosure. However, these embodiments are provided only for illustrative purposes of the present disclosure, and the scope of the present disclosure is not limited thereby.

Before discussing the details, it should be noted that all terms or words used herein and used in the appended claims are not construed as being limited to general and dictionary meanings but will be interpreted based on the meanings and concepts corresponding to the technical ideas of the present disclosure, following the principle that any inventor is allowed to define the concepts of terms as appropriate to describe the disclosure thereof in the best mode.

Therefore, the embodiments described herein are configured merely as one of the most preferable examples of the present disclosure and do not exhaustively represent the technical idea of the present disclosure. Accordingly, it should be appreciated that there may be various equivalents and modifications that can replace these embodiments as of the filing date of the present application.

As used herein, the singular forms are intended to include the plural forms, unless the context clearly indicates otherwise. It will be further understood that the terms "comprise," "include," "contain," "have," and the like when used herein, are intended to specify the presence of stated features, integers, steps, constituent elements, or combinations thereof but do not preclude the possibility of the presence or addition of one or more other features, integers, steps, constituent elements, or combinations thereof.

When various parameters are given herein as a range, preferred range, or enumeration of preferred upper values and preferred lower values, it should be understood to specifically disclose any ranges formed by pairing any upper limit or preferred value and any lower limit or preferred value, regardless of whether such a range is separately disclosed.

When a range of numerical values is mentioned herein, this range is intended to include not only the endpoints but also all integers and fractions within the range, unless otherwise stated.

The scope of the present disclosure is not intended to be limited to the specific values mentioned when defining ranges.

As used herein, the expression "a to b" to represent a numerical range is defined as $\geq a$ and $\leq b$.

A thin film formation method, according to one aspect of the present application, may be a thin film formation method of depositing a thin film by repeatedly performing a first cycle including: performing a first injection by injecting a first precursor compound into a chamber; and performing a second injection by injecting a second precursor compound into the chamber, wherein the first precursor compound is represented by Chemical Formula 1 below, and the second precursor compound is represented by Chemical Formula 2 below.

[Chemical Formula 1] $\quad\quad Si(R_1)_x H_{(4-x)}$

[Chemical Formula 2] $\quad\quad Si_y(R_2)_z H_{(2y+2-z)}$

In Chemical Formulas 1 and 2,

$R_1$ and $R_2$ may be each independently any one selected from the group consisting of fluorine (F), chlorine (Cl), bromine (Br), and iodine (I),

x may be an integer in the range of 1 to 4,

z may be an integer in the range of 0 to 4 when y is 1, and

z may be an integer in the range of 0 to 6 when y is 2 or 3.

In this case, the number after each atom being 0 may mean that the atom is not included.

In addition, Chemical Formula 2 may or may not be identical to Chemical Formula 1.

In the present application, the chamber may refer to a space inside a reactor where a thin film deposition process takes place.

The first cycle may be repeatedly performed 1 or more times and 1,000 or fewer times. For example, the first cycle may be repeatedly performed 50 or more times, 100 or more times, 200 or more times, 300 or more times, 400 or more times, or 500 or more times.

In one embodiment of the present application, in Chemical Formula 1, $R_1$ may be iodine (I), and x may be 2.

For example, the first precursor compound may be $SiI_2H_2$.

In one embodiment of the present application, in Chemical Formula 2, $R_2$ may be chlorine (Cl), y may be 2, and z may be 4 or 5.

For example, the second precursor compound may be $Si_2Cl_4H_2$ or $Si_2Cl_5H$.

In the meantime, in the absence of the second precursor compound, low-temperature ALD behaviors may not be secured smoothly at a process temperature of 500°C or lower, and the morphology characteristics of the deposited thin film may deteriorate.

The thin film formation method may be ALD, chemical vapor deposition (CVD), or a combination thereof, which preferably is ALD, but is not limited thereto.

ALD is a deposition method in which steps of adsorbing a precursor onto a substrate, purging the remaining precursor with a purge gas, reacting with a reaction gas, and then purging the remaining reaction gas with a purge gas are repeatedly performed. When using the ALD method, a film may be formed to a further small thickness, and a highly uniform film may be formed. In addition, when repeatedly performing each step of the ALD method, a thin film may be formed on the substrate to the desired thickness.

In ALD, reactants are required to be highly volatile, stable, and highly reactive. ALD allows a sub-monolayer thin film to grow by a surface reaction during one deposition cycle in a manner in which each reaction raw material is supplied separately. In addition, the ligand of the reaction raw material, adsorbed onto the substrate, may be removed through a chemical reaction with another reaction raw material supplied later. When heating the precursor compound, the reactant, for ALD, the liquid form is much more advantageous in terms of the reaction rate and process than the solid form.

The first precursor compound of the present application, which is a silicon (Si) atom-containing compound, may be a colorless liquid at room temperature.

In one embodiment of the present application, the first cycle may further include: performing a first purge by injecting a first purge gas into the chamber, between the first injection and the second injection; and performing a second purge by injecting a second purge gas into the chamber, after the second injection.

In this case, hydrogen ($H_2$), argon (Ar), nitrogen ($N_2$), helium (He), a noble gas, an inert gas, or a combination thereof may be each independently used as the first purge gas and the second purge gas.

In one embodiment of the present application, hydrogen gas ($H_2$) may be injected simultaneously in the first injection and/or the second injection, thereby adjusting the hydrogen (H) content in the thin film and adjusting the impurity concentration of halogen atoms.

In addition, hydrogen gas ($H_2$) may be injected simultaneously in the first purge and/or the second purge, thereby adjusting the hydrogen (H) content in the thin film and adjusting the impurity concentration of halogen atoms.

In one embodiment of the present specification, the first precursor compound represented by Chemical Formula 1 may be one or more selected from the group consisting of fluorosilane, chlorosilane, bromosilane, iodosilane, difluorosilane, dichlorosilane, dibromosilane, diiodosilane (DIS, $SiI_2H_2$), trifluorosilane, trichlorosilane, tribromosilane, triiodosilane, tetrafluorosilane, tetrachlorosilane, tetrabromosilane, and tetraiodosilane.

For example, the first precursor compound that may be represented by Chemical Formula 1 may be DIS, but is not limited thereto.

In one embodiment of the present application, the second precursor compound represented by Chemical Formula 2 may be one or more selected from the group consisting of silane ($SiH_4$), fluorosilane, chlorosilane, bromosilane, iodosilane, difluorosilane, dichlorosilane, dibromosilane, DIS, trifluorosilane, trichlorosilane, tribromosilane, triiodosilane, tetrafluorosilane, tetrachlorosilane, tetrabromosilane, tetraiodosilane, disilane ($Si_2H_6$), fluorodisilane, chlorodisilane, bromodisilane, iododisilane, difluorodisilane, dichlorodisilane, dibromodisilane, diiododisilane, trifluorodisilane, trichlorodisilane, tribromodisilane, triiododisilane, tetrafluorodisilane, tetrachlorodisilane (TCDS, $Si_2Cl_4H_2$), tetrabromodisilane, tetraiododisilane, pentafluorodisilane, pentachlorodisilane (PCDS, $Si_2Cl_5H$), pentabromodisilane, pentaiododisilane, hexafluorodisilane, hexachlorodisilane, hexabromodisilane, hexaiododisilane, trisilane ($Si_3H_8$), fluorotrisilane, chlorotrisilane, bromotrisilane, iodotrisilane, difluorotrisilane, dichlorotrisilane, dibromotrisilane, diiodotrisilane, trifluorotrisilane, trichlorotrisilane, tribromotrisilane, triiodotrisilane, tetrafluorotrisilane, tetrachlorotrisilane, tetrabromotrisilane, tetraiodotrisilane, pentafluorotrisilane, pentachlorotrisilane, pentabromotrisilane, pentaiodotrisilane, hexafluorotrisilane, hexachlorotrisilane, hexabromotrisilane, and hexaiodotrisilane.

For example, the second precursor compound that may be represented by Chemical Formula 2 may be any one selected from the group consisting of TCDS and PCDS, but is not limited thereto.

In one embodiment of the present application, the thin film formation method may be performed at a process temperature of 350°C or higher and 500°C or lower.

For example, the process temperature may be 350°C or higher and 500°C or lower, 360°C or higher and 500°C or lower, 370°C or higher and 500°C or lower, 380°C or higher and 500°C or lower, 390°C or higher and 500°C or lower, 400°C or higher and 500°C or lower, 370°C or higher and 490°C or lower, 390°C or higher and 485°C or lower, 395°C or higher and 480°C or lower, 400°C or higher and 475°C or lower, 360°C or higher and 480°C or lower, 370°C or higher and 460°C or lower, 380°C or higher and 440°C or lower, 390°C or higher and 430°C or lower, 400°C or higher and 420°C or lower, 350°C or higher and 490°C or lower, 350°C or higher and 480°C or lower, 350°C or higher and 470°C or lower, 350°C or higher and 460°C or lower, 350°C or higher and 450°C or lower, 350°C or higher and 440°C or lower, 350°C or higher and 430°C or lower, 350°C or higher and 420°C or lower, 350°C or higher and 410°C or lower, 350°C or higher and 400°C or lower, 360°C or higher and 450°C or lower, 370°C or higher and 450°C or lower, 380°C or higher and 450°C or lower, 390°C or higher and 450°C or lower, 400°C or higher and 450°C or lower, 410°C or higher and 450°C or lower, 420°C or higher and 450°C or lower, 430°C or higher and 450°C or lower, or 440°C or higher and 450°C or lower.

Specifically, when the first precursor compound is DIS, the process temperature may be 350°C or higher and 500°C or lower, which preferably is 400°C or higher and 500°C or lower and more preferably is 400°C or higher and 450°C or lower.

In the meantime, when the thin film, according to the present application, is formed at a low temperature below 350°C, deposition may fail to occur smoothly. This is because the reaction rate is insufficient, which may further slow down the deposition rate. In addition, the second precursor compound may fail to diffuse sufficiently, which may cause problems with defects or uniformity in the materials and the thin film and thus make the substrate or the thin film unstable.

In addition, when the thin film, according to the present application, is formed at a high temperature above 500°C, deposition may fail to occur smoothly. This may cause the reaction rate to become extremely fast, leading to the generation of impurities, and cause the precursor or reaction gas to decompose, making thin film formation challenging.

In one embodiment, when the first precursor compound is DIS while the second precursor compound is TCDS, a growth rate per cycle (GPC) of the thin film formed by the formation method at a process temperature in the range of 400°C to 450°C may be in the range of 0.1 to 0.3 Å/cycle. In other words, the GPC of the thin film formed by the formation method at a process temperature in the range of 400°C to 450°C may be in the range of 0.1 to 0.3 Å/cycle, 0.12 to 0.28 Å/cycle, 0.14 to 0.26 Å/cycle, 0.16 to 0.24 Å/cycle, 0.18 to 0.24 Å/cycle, 0.19 to 0.24 Å/cycle, 0.20 to 0.24 Å/cycle, 0.215 to 0.24 Å/cycle, 0.18 to 0.22 Å/cycle, 0.19 to 0.22 Å/cycle, 0.20 to 0.22 Å/cycle, or 0.215 to 0.22 Å/cycle.

In one embodiment, when the first precursor compound is DIS while the second precursor compound is PCDS, the GPC of the thin film formed by the formation method at a process temperature in the range of 420°C to 450°C may be in the range of 0.1 to 0.3 Å/cycle. In other words, the GPC of the thin film formed by the formation method at a process temperature in the range of 420°C to 450°C may be in the range of 0.1 to 0.3 Å/cycle, 0.12 to 0.28 Å/cycle, 0.14 to 0.26 Å/cycle, 0.16 to 0.24 Å/cycle, 0.18 to 0.24 Å/cycle, 0.19 to 0.24 Å/cycle, 0.20 to 0.24 Å/cycle, 0.215 to 0.24 Å/cycle, 0.18 to 0.22 Å/cycle, 0.19 to 0.22 Å/cycle, 0.20 to 0.22 Å/cycle, or 0.215 to 0.22 Å/cycle.

In one embodiment, a canister for the first precursor compound may have a temperature of 0°C or higher and 50°C or lower.

For example, the temperature of the canister for the first precursor compound may be 0°C or higher and 50°C or lower, 5°C or higher and 45°C or lower, 10°C or higher and 40°C or lower, 15°C or higher and 35°C or lower, 20°C or higher and 25°C or lower, 20°C or higher and 30°C or lower, 25°C or higher and 30°C or lower, 5°C or higher and 30°C or lower, 10°C or higher and 30°C or lower, or 15°C or higher and 30°C or lower.

In addition, a canister for the second precursor compound may have a temperature of 0°C or higher and 30°C or lower.

For example, the temperature of the canister for the second precursor compound may be 0°C or higher and 30°C or lower, 0°C or higher and 25°C or lower, 0°C or higher and 20°C or lower, 5°C or higher and 25°C or lower, 5°C or higher and 20°C or lower, 5°C or higher and 15°C or lower, 10°C or higher and 30°C or lower, 10°C or higher and 25°C or lower, 10°C or higher and 20°C or lower, 10°C or higher and 15°C or lower, 15°C or higher and 30°C or lower, 15°C or higher and 25°C or lower, or 15°C or higher and 20°C or lower.

In thin film formation methods, a canister is used to supply a source gas and a reaction gas into a reaction chamber. Typically, the canister vaporizes precursor compounds to produce the source gas and the reaction gas and then supplies the produced gases into the chamber.

When the temperature of the canister does not fall within the above numerical range, uniformity in the thickness of the thin film, formed by the thin film formation method, may be significantly reduced.

This is because a uniform film is challenging to obtain due to an insufficient supply of the precursor compounds to the chamber below the minimum temperature range and due to deterioration caused by thermal energy or an excessive supply of the precursor compounds to the chamber above the maximum temperature range.

In one embodiment, the injection time of the first precursor compound may be 1 second or more and 30 seconds or less, and the injection time of the second precursor compound may be 1 second or more and 30 seconds or less. Preferably, the injection time of the first precursor compound is 1 second or more and 15 seconds or less, and the injection time of the second precursor compound is 1 second or more and 15 seconds or less.

For example, the injection time of the first precursor compound may be 1 second or more and 20 seconds or less, 1 second or more and 15 seconds or less, 2 seconds or more and 15 seconds or less, 3 seconds or more and 15 seconds or less, 4 seconds or more and 15 seconds or less, 5 seconds or more and 15 seconds or less, 2 seconds or more and 10 seconds or less, 3 seconds or more and 10 seconds or less, 4 seconds or more and 10 seconds or less, 5 seconds or more and 10 seconds or less, 1 second or more and 10 seconds or less, 1 second or more and 8 seconds or less, 1 second or more and 6 seconds or less, or 1 second or more and 5 seconds or less.

In addition, the injection time of the second precursor compound may be 1 second or more and 20 seconds or less, 1 second or more and 15 seconds or less, 2 seconds or more and 15 seconds or less, 3 seconds or more and 15 seconds or less, 4 seconds or more and 15 seconds or less, 5 seconds or more and 15 seconds or less, 2 seconds or more and 10 seconds or less, 3 seconds or more and 10 seconds or less, 4 seconds or more and 10 seconds or less, 5 seconds or more and 10 seconds or less, 1 second or more and 10 seconds or less, 1 second or more and 8 seconds or less, 1 second or more and 6 seconds or less, or 1 second or more and 5 seconds or less.

When the process is performed while the injection time of the first precursor compound and the injection time of the second precursor compound exceed or fall below the above numerical ranges, it may be challenging to form an appropriate thin film.

Specifically, when the injection time of the first precursor compound falls below the above numerical range, the reactant necessary for thin film formation may be insufficient, so a thin film having an appropriate thickness may fail to be formed. On the other hand, when the injection time of the first precursor compound exceeds the above numerical range, the composition ratio of the thin film formed may be inconsistent due to impurities generated by the compound remaining after the reaction.

In addition, the injection time of the second precursor compound may vary depending on the type of the first precursor compound.

For example, when the first precursor compound is DIS, the injection time of the second precursor compound may be 1 second or more and 20 seconds or less, 2 seconds or more and 19 seconds or less, 3 seconds or more and 18 seconds or less, or 4 seconds or more and 17 seconds or less. Preferably, the injection time of the second precursor compound is 5 seconds or more and 15 seconds or less.

When the injection time of the second precursor compound is less than 1 second, the residual amount of the first precursor compound, the reactant, may increase, causing an inappropriate reaction. In addition, the thin film layer may be deposited non-uniformly due to the generation of impurities. On the other hand, when the injection time of the second precursor compound exceeds 30 seconds, impurities may be generated by the second precursor compound.

In one embodiment, the injection time of the first purge gas in the first purge may be 1 second or more and 1 minute or less, and the injection time of the second purge gas in the second purge may be 1 second or more and 1 minute or less.

In one embodiment, the injection time of the first purge gas in the first purge may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

In addition, the injection time of the second purge gas in the second purge may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

When the injection time of the first or second purge gas falls below the above numerical range, the residual amount of the first or second precursor compound may increase, causing an inappropriate reaction. In addition, the thin film layer may be deposited non-uniformly because impurities are not purged.

In one embodiment, the thin film formed in the case where the first cycle is repeatedly performed 1 or more times and 70 or fewer times may be a silicon seed layer. In this case, the silicon seed layer may form nucleation islands, which may be formed randomly.

In addition, when additional film deposition is performed after the nucleation islands are formed, the film may grow around the nucleation islands.

The first cycle may, for example, be repeatedly performed 65 or fewer times, 60 or fewer times, 55 or fewer times, 50 or fewer times, 45 or fewer times, 40 or fewer times, 35 or fewer times, 30 or fewer times, 25 or fewer times, 20 or fewer times, 15 or fewer times, or 10 or fewer times.

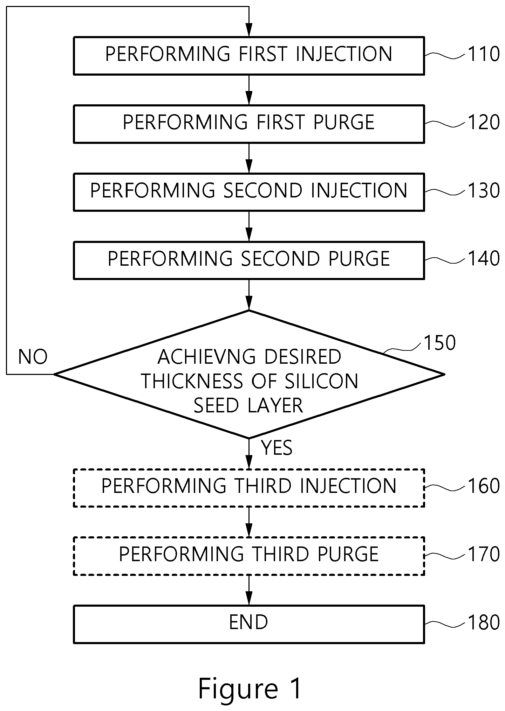

FIG. 1 illustrates each order of the first injection, the first purge, the second injection, and the second purge of the first cycle.

In one embodiment, the thin film formation method may further include: performing a third injection by injecting a compound containing hydrogen (H), nitrogen (N), oxygen (O), or a combination thereof into the chamber, after forming the silicon seed layer.

FIG. 1 illustrates each order of the third injection and a third purge. The third injection and the third purge may be performed optionally when the silicon seed layer is required to be nitrided or oxidized. When the third injection and the third purge are not performed, the third injection (160) and the third purge (170) in FIG. 1 may be skipped, and the process may end (180).

The compound in the third injection may specifically refer to hydrogen ($H_2$), nitrogen ($N_2$), ammonia ($NH_3$), oxygen ($O_2$), ozone ($O_3$), or a combination thereof. When the third injection is further included, the silicon seed layer may be nitrided or oxidized.

For example, the silicon seed layer may be a silicon nitride film or a doped silicon nitride film, and the oxide film may be a silicon oxide film or a doped silicon oxide film.

In one embodiment, a third purge gas may be injected into the chamber after the third injection. In this case, hydrogen ($H_2$), argon (Ar), nitrogen ($N_2$), helium (He), a noble gas, an inert gas, or a combination thereof may be used as the third purge gas.

In one embodiment, the injection time of the third purge gas in the third purge may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

When the injection time of the third purge gas falls below the above numerical range, the residual amount of the compound injected in the third injection may increase, causing an inappropriate reaction. In addition, the thin film layer may be deposited non-uniformly because impurities are not purged.

In one embodiment, a silicon thin film may be formed by further repeatedly performing a second cycle including: performing the first injection by injecting the first precursor compound onto the silicon seed layer, after forming the silicon seed layer; and performing the second injection by injecting the second precursor compound.

In other words, this means that the silicon thin film may be formed by further repeatedly performing the second cycle after the first cycle repeatedly performed 1 or more times and 70 or fewer times.

The second cycle may be repeatedly performed 1 or more times and 500 or fewer times. For example, the second cycle may be repeatedly performed 400 or fewer times, 300 or fewer times, 200 or fewer times, or 100 or fewer times.

In this case, the silicon seed layer may be a silicon seed layer that has not undergone the third injection or may be a silicon seed layer that has been nitrided or oxidized by further including the third injection. In addition, the silicon seed layer may refer to a seed layer formed by injecting the third purge gas after the third injection.

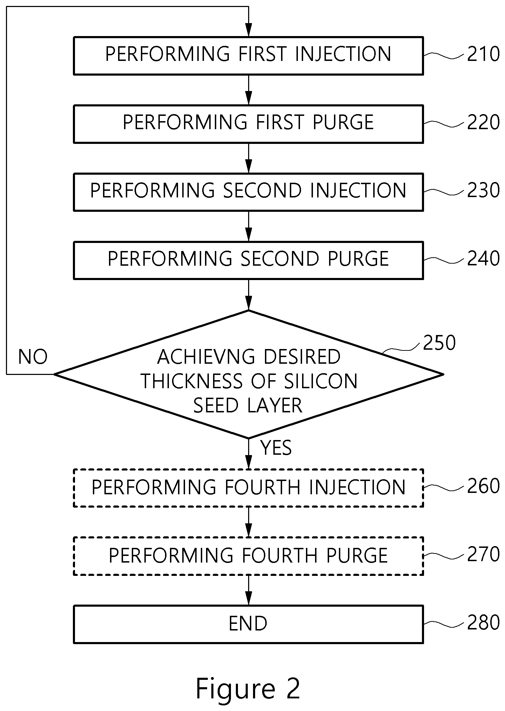

FIG. 2 illustrates each order of the first injection, the first purge, the second injection, and the second purge of the second cycle.

In one embodiment, the silicon thin film formed on the silicon seed layer may be in an amorphous state, a mixed state of an amorphous state and a nanocrystalline state, or a nanocrystalline state.

Typically, in the case of ALD, atoms or molecules are arranged disorderly without a regular pattern. This typically occurs during a rapid cooling process or particular chemical process and occurs when there is not enough time for the formation of crystal structures.

Thin films in an amorphous state may be produced by ALD processes, and materials in such a state typically exhibit isotropic thermal, mechanical, and electrical properties.

A nanocrystalline state refers to a material having a nanometer-scale crystalline structure. Nanocrystals have unique physical properties due to having small size and high surface-to-volume ratio. Materials in such a state may exhibit different properties from those of materials in an amorphous state in terms of electrical, optical, and mechanical properties. Thin films in a nanocrystalline state may be formed through ALD processes.

In terms of thin film deposition processes, the morphology of a thin film may be determined during a deposition process under conditions such as specific temperature, pressure, and deposition time or may be determined by a crystallization process after depositing the thin film.

In the present application, the surface morphology of the thin film may be controlled by the types of the first precursor compound and the second precursor compound.

In addition, in the case of the formation method of the present application, a thin film in a nanocrystalline state or a mixed state of an amorphous state and a nanocrystalline state may be obtained without separately performing additional heat treatment after deposition.

In one embodiment, the silicon thin film may be a silicon (Si) thin film in a purely amorphous state free of carbon (C) and/or nitrogen (N). However, carbon (C), nitrogen (N), and/or oxygen (O) may be detected from the thin film due to oxidation or contamination of the surface of the thin film.

In one embodiment, the thin film formed by the formation method may have a grain size of 30 nm or greater and 50 nm or smaller, as measured with a scanning electron microscope (SEM).

For example, the grain size may be 30 nm or greater and 50 nm or smaller, 30.5 nm or greater and 49 nm or smaller, 31 nm or greater and 48 nm or smaller, 31 nm or greater and 46 nm or smaller, 31.7 nm or greater and 45.2 nm or smaller, or 37.3 nm or greater and 47.6 nm or smaller.

In one embodiment, additional heat treatment may be performed on the silicon thin film in an amorphous state, formed by the formation method of the present application, thereby forming a crystalline silicon thin film.

In this case, hydrogen ($H_2$) may be injected simultaneously in the first injection, the second injection, the third injection, the first purge, the second purge, the third purge, a fourth injection, a fourth purge, or a combination thereof, thereby adjusting the hydrogen (H) content in the thin film. In addition, the grain size of the crystalline silicon thin film may be adjusted by adjusting the hydrogen (H) content in the thin film.

In one embodiment, the thin film formed by the formation method may have a roughness (Rq) value of 0.1 nm or greater and 0.5 nm or smaller, as measured with an atomic force microscope (AFM) at a scan size of 5 $\mu$m.

For example, the Rq value may be 0.1 nm or greater and 0.5 nm or smaller, 0.15 nm or greater and 0.4 nm or smaller, 0.15 nm or greater and 0.3 nm or smaller, 0.2 nm or greater and 0.25 nm or smaller, 0.2 nm or greater and 0.3 nm or smaller, 0.2 nm or greater and 0.35 nm or smaller, 0.2 nm or greater and 0.4 nm or smaller, 0.21 nm or greater and 0.39 nm or smaller, 0.22 nm or greater and 0.36 nm or smaller, 0.3 nm or greater and 0.5 nm or smaller, 0.31 nm or greater and 0.49 nm or smaller, 0.32 nm or greater and 0.48 nm or smaller, 0.33 nm or greater and 0.46 nm or smaller, or 0.34 nm or greater and 0.45 nm or smaller.

In one embodiment, the thin film formed by the formation method may have a roughness (Ra) value of 0.1 nm or greater and 0.4 nm or smaller, as measured with an AFM at a scan size of 5 $\mu$m.

For example, the Ra value may be 0.1 nm or greater and 0.4 nm or smaller, 0.12 nm or greater and 0.35 nm or smaller, 0.14 nm or greater and 0.3 nm or smaller, 0.15 nm or greater and 0.29 nm or smaller, 0.17 nm or greater and 0.28 nm or smaller, 0.17 nm or greater and 0.3 nm or smaller, 0.17 nm or greater and 0.35 nm or smaller, 0.17 nm or greater and 0.4 nm or smaller, 0.2 nm or greater and 0.4 nm or smaller, 0.21 nm or greater and 0.39 nm or smaller, 0.22 nm or greater and 0.38 nm or smaller, 0.23 nm or greater and 0.36 nm or smaller, or 0.24 nm or greater and 0.35 nm or smaller.

In one embodiment, the thin film formation method may further include: performing the fourth injection by injecting a compound containing hydrogen (H), nitrogen (N), oxygen (O), or a combination thereof into the chamber, after forming the silicon. The compound in the fourth injection may specifically refer to hydrogen ($H_2$), nitrogen ($N_2$), ammonia ($NH_3$), oxygen ($O_2$), ozone ($O_3$), or a combination thereof. When the third injection is further included, the silicon seed layer may be nitrided or oxidized.

For example, the silicon seed layer may be a silicon nitride film or a doped silicon nitride film, and the oxide film may be a silicon oxide film or a doped silicon oxide film.

In one embodiment, a fourth purge gas may be injected into the chamber after the fourth injection. In this case, hydrogen ($H_2$), argon (Ar), nitrogen ($N_2$), helium (He), a noble gas, an inert gas, or a combination thereof may be used as the fourth purge gas.

FIG. 2 illustrates each order of the fourth injection and the fourth purge. The fourth injection and the fourth purge may be performed optionally when the silicon thin film is required to be nitrided or oxidized. When the fourth injection and the fourth purge are not performed, the fourth injection (260) and the fourth purge (270) in FIG. 2 may be skipped, and the process may end (280).

In one embodiment, the injection time of the fourth purge gas in the fourth purge may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

When the injection time of the fourth purge gas falls below the above numerical range, the residual amount of the compound injected in the fourth injection may increase, causing an inappropriate reaction. In addition, the thin film layer may be deposited non-uniformly because impurities are not purged.

Hereinafter, the present application will be described in more detail using the following preparation examples. However, the present application is not limited thereto.

**[Preparation Example]**

A thin film was formed using the first precursor compound and the second precursor compound with ALD equipment.

A substrate used in this experiment was a p-type $SiO_2$ (110 nm) wafer with a resistivity of 0.02 $\Omega \cdot$cm. Before deposition, the p-type Si wafer was sonicated in acetone, ethanol, and deionized water (DI water) for 10 minutes each and cleaned. The native oxide film on the Si wafer was immersed in a 1% HF solution ($HF:H_2O$ = 1:100) for 10 seconds and then removed. The HF-cleaned Si wafer was immediately transferred to an ALD chamber.

In addition, as shown in Table 1 below, the first precursor compound used in thin film formation is DIS.

TCDS and PCDS were each independently used as the second precursor compound.

A canister for the first precursor compound had a temperature maintained at 25°C in Preparation Example 1 and a temperature maintained at 5°C in Preparation Example 2.

The first precursor compound, argon (Ar), the second precursor compound, and argon (Ar) were supplied in sequence to constitute one cycle.

In Preparation Example 1, the cycle was repeatedly performed 70 times, and in Preparation Example 2, the cycle was repeatedly performed 180 times.

The injection time of the first precursor compound (DIS) was adjusted to 3 to 10 seconds. In this case, the injection amount of the first precursor compound (DIS) was 100 sccm, and the process pressure was in the range of 3.2 to 4.0 Torr.

The injection time of the second precursor compound used in Preparation Examples 1 and 2 was adjusted to 5 to 15 seconds. In this case, the injection amount of the second precursor compound was 100 sccm, and the process pressure was in the range of 3.0 to 4.0 Torr.

In Preparation Example 3, the cycle was repeatedly performed 70 times, and in Preparation Example 4, the cycle was repeatedly performed 200 times.

The injection time of the first precursor compound (DIS) was adjusted to 3 to 10 seconds. In this case, the injection amount of the first precursor compound (DIS) was 100 sccm, and the process pressure was in the range of 3.2 to 4.0 Torr.

The injection time of the second precursor compound used in Preparation Examples 3 and 4 was adjusted to 5 to 15 seconds. In this case, the injection amount of the second precursor compound was 100 sccm, and the process pressure was in the range of 3.0 to 4.0 Torr.

In other words, in Preparation Examples 1 and 3, a silicon seed layer was formed by repeatedly performing the first injection, the first purge, the second injection, and the second purge 70 times in sequence without performing the third injection and the third purge in FIG. 1.

In addition, in Preparation Examples 2 and 4, a silicon seed layer was formed by repeatedly performing the first injection, the first purge, the second injection, and the second purge 70 times in sequence without performing the third injection and the third purge in FIG. 1, as in Preparation Examples 1 and 3. Then, a silicon thin film was formed on the silicon seed layer by further repeatedly performing the first injection, the first purge, the second injection, and the second purge in FIG. 2 110 times and 130 times in Preparation Examples 2 and 4, respectively.

Table 1 below shows the process conditions for thin film formation according to each preparation example.

[Table 1]

|  | First Precursor | Second Precursor | Injection Time of First Precursor Compound (seconds (s)) | First Purge Time (seconds (s)) | Injection Time of Second Precursor Compound (seconds (s)) | Second Purge Time (seconds (s)) | Process Temperature (°C) | Cycle (times) |
|---|---|---|---|---|---|---|---|---|
| Preparation Example 1 | DIS | TCDS | 3 to 10 | 10 | 5 to 15 | 10 | 400 to 500 | 70 |
| Preparation Example 2 | DIS | TCDS | 3 to 10 | 10 | 5 to 15 | 10 | 400 to 500 | 180 |
| Preparation Example 3 | DIS | PCDS | 3 to 10 | 10 | 5 to 15 | 10 | 400 to 450 | 70 |
| Preparation Example 4 | DIS | PCDS | 3 to 10 | 10 | 5 to 15 | 10 | 400 to 450 | 200 |

In Table 1, DIS stands for diiodosilane, TCDS stands for tetrachlorodisilane, and PCDS stands for pentachlorodisilane.

In Preparation Example 5, ammonia ($NH_3$) and argon (Ar) were further supplied in sequence to the silicon thin film formed by Preparation Example 2.

In Preparation Example 6, ozone ($O_3$) and argon (Ar) were further supplied in sequence to the silicon thin film formed by Preparation Example 2.

In Preparation Example 7, ammonia ($NH_3$) and argon (Ar) were further supplied in sequence to the silicon thin film formed by Preparation Example 4.

In Preparation Example 8, ozone ($O_3$) and argon (Ar) were further supplied in sequence to the silicon thin film formed by Preparation Example 4.

In other words, in Preparation Examples 5 to 8, the fourth injection and the fourth purge in FIG. 2 were further repeatedly performed on the silicon thin films formed by Preparation Examples 2 and 4 to oxidize or nitride the silicon thin films.

Table 2 below shows the process conditions for silicon thin film formation according to Preparation Examples 5 to 8.

[Table 2]

|  | Injection Compound | Injection Time of Compound (seconds (s)) | Purge Time (seconds (s)) | Process Temperature (°C) | Cycle (times) |
|---|---|---|---|---|---|
| Preparation Example 5 | Ammonia ($NH_3$) | 3 to 10 | 10 | 400 to 500 | 100 |
| Preparation Example 6 | Ozone ($O_3$) | 3 to 10 | 10 | 400 to 500 | 100 |
| Preparation Example 7 | Ammonia ($NH_3$) | 3 to 10 | 10 | 400 to 500 | 100 |
| Preparation Example 8 | Ozone ($O_3$) | 3 to 10 | 10 | 400 to 500 | 100 |

[Evaluation Example 1 - Change in GPC of Thin Film by Injection Time of First Precursor Compound]

Under the process conditions described in Table 1, the injection time of the first precursor compound was varied in the range of 3 to 10 seconds to form each of the thin films according to the preparation examples. Then, the GPC of each thin film was measured.

Hereinafter, the GPC in Evaluation Examples 1 to 3 was calculated using the following Equation 1.

[Equation 1]

$$\text{GPC (Å/cycle)} = \text{deposition thickness/number of ALD cycles}$$

The deposition thickness in Equation 1 was measured with an ellipsometer and confirmed with a field emission scanning electron microscope (FE-SEM).

At a process temperature of 430°C, an ALD process, according to each formation method of Preparation Examples 2 and 4, was performed. During the process, the self-limiting reaction was confirmed by measuring the injection time of the first precursor (source feeding time) exhibiting a constant GPC of the thin film.

[Evaluation Example 2 - Change in GPC of Thin Film by Injection Time of Second Precursor Compound]

Under the process conditions described in Table 1, the injection time of the second precursor compound in Preparation Example 2 was varied in the range of 5 to 15 seconds to form the silicon thin films according to the preparation examples. Then, the GPC of each thin film was measured.

At a process temperature of 430°C, an ALD process was performed according to the formation method of Preparation Example 2, using the first precursor compound and the second precursor compound in Preparation Example 2 as a source and a reaction gas (reactant), respectively. During the process, the self-limiting reaction was confirmed by measuring the injection time of the second precursor exhibiting a constant GPC of the thin film.

In the meantime, under the process conditions described in Table 1, the injection time of the second precursor compound in Preparation Example 4 was varied in the range of 5 to 15 seconds to form the thin films according to the preparation examples. Then, the GPC of each thin film was measured.

At a process temperature of 430°C, an ALD process was performed according to the formation method of Preparation Example 4, using the first precursor compound and the second precursor compound in Preparation Example 4 as a source and a reaction gas (reactant), respectively. During the process, the self-limiting reaction was confirmed by measuring the injection time of the second precursor exhibiting a constant GPC of the thin film.

[Evaluation Example 3 - Change in GPC of Thin Film by Process Temperature]

Under the process conditions described in Table 1, the process temperature was varied in the range of 400°C to 450°C in the case of Preparation Example 2 and varied in the range of 420°C to 450°C in the case of Preparation Example 4 to form the thin films according to the preparation examples. Then, the GPC of each silicon thin film was measured.

[Evaluation Example 4 - Grain Size Analysis of Preparation Examples 2 and 4]

SEM analysis was performed to examine the grain size in the case of Preparation Example 2, where DIS and TCDS were used as the first precursor compound and the second precursor compound, respectively.

SEM analysis was performed to examine the grain size in the case of Preparation Example 4, where DIS and PCDS were used as the first precursor compound and the second precursor compound, respectively.

[Evaluation Example 5 - AFM analysis of Preparation Examples 2, 4, and 5 to 81

AFM analysis was performed to examine the morphology of the thin film in the case of Preparation Example 2, where DIS and TCDS were used as the first precursor compound and the second precursor compound, respectively.

AFM analysis was performed to examine the morphology of the thin film in the case of Preparation Example 4, where DIS and PCDS were used as the first precursor compound and the second precursor compound, respectively.

AFM analysis was performed to examine the morphology of the thin film in the case of Preparation Example 5, where ammonia ($NH_3$), used as the compound in the third injection, was supplied to the thin film formed by Preparation Example 2.

AFM analysis was performed to examine the morphology of the thin film in the case of Preparation Example 6, where ozone ($O_3$), used as the compound in the third injection, was supplied to the thin film formed by Preparation Example 2.

AFM analysis was performed to examine the morphology of the thin film in the case of Preparation Example 7, where ammonia ($NH_3$), used as the compound in the third injection, was supplied to the thin film formed by Preparation Example 4.

AFM analysis was performed to examine the morphology of the thin film in the case of Preparation Example 8,

where ozone ($O_3$), used as the compound in the third injection, was supplied to the thin film formed by Preparation Example 4.

[Evaluation Example 6 - X-ray diffraction analysis (XRD) of Preparation Examples 2, 4, and 5 to 8]

XRD analysis was performed to examine the morphology of the thin film in the case of Preparation Example 2, where DIS and TCDS were used as the first precursor compound and the second precursor compound, respectively.
XRD analysis was performed to examine the morphology of the thin film in the case of Preparation Example 4, where DIS and PCDS were used as the first precursor compound and the second precursor compound, respectively.
XRD analysis was performed to examine the morphology of the thin film in the case of Preparation Example 5, where ammonia ($NH_3$), used as the compound in the third injection, was supplied to the thin film formed by Preparation Example 2.
XRD analysis was performed to examine the morphology of the thin film in the case of Preparation Example 6, where ozone ($O_3$), used as the compound in the third injection, was supplied to the thin film formed by Preparation Example 2.
XRD analysis was performed to examine the morphology of the thin film in the case of Preparation Example 7, where ammonia ($NH_3$), used as the compound in the third injection, was supplied to the thin film formed by Preparation Example 4.
XRD analysis was performed to examine the morphology of the thin film in the case of Preparation Example 8, where ozone ($O_3$), used as the compound in the third injection, was supplied to the thin film formed by Preparation Example 4.
Through the thin film formation described above, it was confirmed that, in the case of the formation method using the first precursor compound and the second precursor compound in Preparation Examples 2 and 4, a silicon thin film having excellent properties could be formed by ALD even during a low-temperature process at 500°C or lower.
The scope of the present application is defined by the appended claims rather than the detailed description presented above. All changes or modifications derived from the meaning and scope of the claims and the concept of equivalents should be construed to fall within the scope of the present application.

[EXPLANATION OF REFERENCE NUMERALS]

110: PERFORMING FIRST INJECTION OF FIRST CYCLE
120: PERFORMING FIRST PURGE OF FIRST CYCLE
130: PERFORMING SECOND INJECTION OF FIRST CYCLE
140: PERFORMING SECOND PURGE OF FIRST CYCLE
150: DETERMINING WHETHER TO REPEATEDLY PERFORM FIRST CYCLE
160: PERFORMING THIRD INJECTION
170: PERFORMING THIRD PURGE
180: COMPLETING FORMATION OF SILICON SEED LAYER
210: PERFORMING FIRST INJECTION OF SECOND CYCLE
220: PERFORMING FIRST PURGE OF SECOND CYCLE
230: PERFORMING SECOND INJECTION OF SECOND CYCLE
240: PERFORMING SECOND PURGE OF SECOND CYCLE
250: DETERMINING WHETHER TO REPEATEDLY PERFORM SECOND CYCLE
260: PERFORMING FOURTH INJECTION
270: PERFORMING FOURTH PURGE
280: COMPLETING FORMATION OF SILICON THIN FILM

**Claims**

1. A thin film formation method of depositing a thin film by repeatedly performing a first cycle comprising:

   performing a first injection by injecting a first precursor compound into a chamber; and
   performing a second injection by injecting a second precursor compound into the chamber,
   wherein the first precursor compound is represented by Chemical Formula 1 below, and

the second precursor compound is represented by Chemical Formula 2 below,

[Chemical Formula 1]        $Si(R_1)_x H_{(4-x)}$

[Chemical Formula 2]        $Si_y(R_2)_z H_{(2y+2-z)}$

where in Chemical Formulas 1 and 2,

$R_1$ and $R_2$ are each independently any one selected from the group consisting of fluorine (F), chlorine (Cl), bromine (Br), and iodine (I),
x is an integer in a range of 1 to 4,
z is an integer in a range of 0 to 4 when y is 1, and
z is an integer in a range of 0 to 6 when y is 2 or 3.

2. The thin film formation method of claim 1, wherein the first cycle further comprises:

performing a first purge by injecting a first purge gas into the chamber,
between the first injection and the second injection; and
performing a second purge by injecting a second purge gas into the chamber, after the second injection.

3. The thin film formation method of claim 2, wherein hydrogen ($H_2$) is further injected in the first injection, the second injection, the first purge, the second purge, or a combination thereof.

4. The thin film formation method of claim 1, wherein the first precursor compound represented by Chemical Formula 1 is one or more selected from the group consisting of fluorosilane, chlorosilane, bromosilane, iodosilane, difluorosilane, dichlorosilane, dibromosilane, diiodosilane, trifluorosilane, trichlorosilane, tribromosilane, triiodosilane, tetrafluorosilane, tetrachlorosilane, tetrabromosilane, and tetraiodosilane.

5. The thin film formation method of claim 1, wherein the second precursor compound represented by Chemical Formula 2 is one or more selected from the group consisting of silane ($SiH_4$), fluorosilane, chlorosilane, bromosilane, iodosilane, difluorosilane, dichlorosilane, dibromosilane, diiodosilane, trifluorosilane, trichlorosilane, tribromosilane, triiodosilane, tetrafluorosilane, tetrachlorosilane, tetrabromosilane, tetraiodosilane, disilane ($Si_2H_6$), fluorodisilane, chlorodisilane, bromodisilane, iododisilane, difluorodisilane, dichlorodisilane, dibromodisilane, diiododisilane, trifluorodisilane, trichlorodisilane, tribromodisilane, triiododisilane, tetrafluorodisilane, tetrachlorodisilane, tetrabromodisilane, tetraiododisilane, pentafluorodisilane, pentachlorodisilane, pentabromodisilane, pentaiododisilane, hexafluorodisilane, hexachlorodisilane, hexabromodisilane, hexaiododisilane, trisilane ($Si_3H_8$), fluorotrisilane, chlorotrisilane, bromotrisilane, iodotrisilane, difluorotrisilane, dichlorotrisilane, dibromotrisilane, diiodotrisilane, trifluorotrisilane, trichlorotrisilane, tribromotrisilane, triiodotrisilane, tetrafluorotrisilane, tetrachlorotrisilane, tetrabromotrisilane, tetraiodotrisilane, pentafluorotrisilane, pentachlorotrisilane, pentabromotri silane, pentaiodotrisilane, hexafluorotrisilane, hexachlorotrisilane, hexabromotrisilane, and hexaiodotrisilane.

6. The thin film formation method of claim 1, wherein the thin film formation method is performed at a process temperature of 350°C or higher and 500°C or lower.

7. The thin film formation method of claim 1, wherein the first cycle is repeatedly performed 1 or more times and 70 or fewer times, and
the thin film formed by repeatedly performing the first cycle is a silicon seed layer.

8. The thin film formation method of claim 7, further comprising:
performing a third injection by injecting a compound comprising hydrogen (H), nitrogen (N), oxygen (O), or a combination thereof into the chamber,
wherein the silicon seed layer is nitrided or oxidized.

9. The thin film formation method of claim 8, further comprising:

performing a third purge by injecting a third purge gas into the chamber,
after the third injection.

**10.** The thin film formation method of any one of claims 7 to 9, wherein a silicon thin film is formed by further repeatedly performing a second cycle comprising:

performing the first injection by injecting the first precursor compound onto the silicon seed layer; and
performing the second injection by injecting the second precursor compound, and

the silicon thin film formed on the silicon seed layer is in an amorphous state, a mixed state of an amorphous state and a nanocrystalline state, or a nanocrystalline state.

**11.** The thin film formation method of claim 10, wherein the silicon thin film is nitrided or oxidized.

**12.** The thin film formation method of claim 10, further comprising:
performing a fourth injection by injecting a compound comprising hydrogen (H), nitrogen (N), oxygen (O), or a combination thereof into the chamber.

**13.** The thin film formation method of claim 12, further comprising:
performing a fourth purge by injecting a fourth purge gas into the chamber, after the fourth injection.

PERFORMING FIRST INJECTION — 110

PERFORMING FIRST PURGE — 120

PERFORMING SECOND INJECTION — 130

PERFORMING SECOND PURGE — 140

NO

ACHIEVNG DESIRED THICKNESS OF SILICON SEED LAYER — 150

YES

PERFORMING THIRD INJECTION — 160

PERFORMING THIRD PURGE — 170

END — 180

Figure 1

Figure 2

Europäisches
Patentamt

European
Patent Office

Office européen
des brevets

# EUROPEAN SEARCH REPORT

Application Number

EP 25 18 0601

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/221699 A1 (ORIHASHI YUGO [JP] ET AL) 3 August 2017 (2017-08-03) | 1-7,10 | INV.<br>C23C16/24 |
| Y | * figure 5 *<br>* paragraphs [0005], [0025], [0027] *<br>* paragraphs [0032], [0178], [0097], [0101], [0078] * | 1,8,9,<br>11-13 | C23C16/455<br>C23C16/56 |
| | ----- | | |
| X | US 2023/170215 A1 (HORITA HIDEKI [JP] ET AL) 1 June 2023 (2023-06-01) | 1 | |
| Y | * paragraph [0038]; figure 4 *<br>* paragraph [0025] * | 9,13 | |
| | ----- | | |
| Y | US 2015/303058 A1 (KUMMEL ANDREW C [US] ET AL) 22 October 2015 (2015-10-22)<br>* paragraph [0006] * | 1 | |
| | ----- | | |
| Y | CUI ZHENJIANG ET AL: "Rapid thermal oxidation of silicon in ozone", JOURNAL OF APPLIED PHYSICS, AMERICAN INSTITUTE OF PHYSICS, 2 HUNTINGTON QUADRANGLE, MELVILLE, NY 11747, vol. 87, no. 11, 1 June 2000 (2000-06-01), pages 8181-8186, XP012049219, ISSN: 0021-8979, DOI: 10.1063/1.373515<br>* abstract * | 8,11,12 | TECHNICAL FIELDS SEARCHED (IPC)<br><br>C23C |
| | ----- | | |
| Y | KR 2004 0057781 A (HYNIX SEMICONDUCTOR INC) 2 July 2004 (2004-07-02)<br>* paragraph [0023] - paragraph [0024] * | 8,11,12 | |
| | ----- | | |

The present search report has been drawn up for all claims

| Place of search | Date of completion of the search | Examiner |
|---|---|---|
| The Hague | 11 November 2025 | Mauchauffé, Rodolphe |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 0601

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2025

| Patent document cited in search report | Publication date | Patent family member(s) | | Publication date |
|---|---|---|---|---|
| US 2017221699 A1 | 03-08-2017 | CN | 107026077 A | 08-08-2017 |
| | | JP | 6560991 B2 | 14-08-2019 |
| | | JP | 2017135344 A | 03-08-2017 |
| | | KR | 20170091049 A | 08-08-2017 |
| | | US | 2017221699 A1 | 03-08-2017 |
| US 2023170215 A1 | 01-06-2023 | CN | 112735939 A | 30-04-2021 |
| | | JP | 7065818 B2 | 12-05-2022 |
| | | JP | 2021068864 A | 30-04-2021 |
| | | KR | 20210050445 A | 07-05-2021 |
| | | KR | 20230006435 A | 10-01-2023 |
| | | SG | 10202009323W A | 28-05-2021 |
| | | TW | 202123322 A | 16-06-2021 |
| | | US | 2021125828 A1 | 29-04-2021 |
| | | US | 2023170215 A1 | 01-06-2023 |
| US 2015303058 A1 | 22-10-2015 | US | 2015303058 A1 | 22-10-2015 |
| | | US | 2018033610 A1 | 01-02-2018 |
| KR 20040057781 A | 02-07-2004 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 101436564